# EUROPÄISCHE PATENTANMELDUNG

(11) **EP 3 573 112 A1**
(43) Veröffentlichungstag der Anmeldung: **27.11.2019**
(21) Anmeldenummer: 18174264.4
(22) Anmeldetag: 25.05.2018
(51) Int. Cl.: H01L 31/048, H02S 10/40, B32B 17/10

(54) **VERBUND-BAUELEMENT MIT SOLARZELLEN FÜR DIE MOTORHAUBE EINES KRAFTFAHRZEUGS**

(71) Anmelder: A2 - Solar Advanced and Automotive Solar Systems GmbH, 99099 Erfurt (DE)
(72) Erfinder: Wecker, Reinhard, 99425 Weimar (DE)
(74) Vertreter: Lohr, Jöstingmeier & Partner

(57) **Zusammenfassung**

Ein Bauelement für die Motorhaube eines Fahrzeugs, umfasst einen Schichtaufbau in der folgenden Reihenfolge mit einem Substrat (110) aus einem Glasfaser- oder Kohlefaser-Verbundwerkstoff, einer ersten Zwischenfolie (120), wenigstens einer Solarzelle (130), einer zweiten Zwischenfolie (140), einer Glasscheibe (150) aus Sicherheitsglas (ESG), welches bevorzugt durch eine spezielle Wärmebehandlung eine erhöhte Stoß- und Schlagfestigkeit aufweist, einer dritten Zwischenfolie (160) und einer Schutzfolie (170). Dadurch kann eine höhere Stabilität sowie eine bessere Krafteinleitung verbunden mit einer besseren Dämpfung beim Aufprall von Fußgängern erreicht werden.

## Beschreibung

### Technisches Gebiet

Die Erfindung betrifft ein Bauelement mit Solarzellen, welches als Deckel bzw. Solarmodul für Motorhauben von Kraftfahrzeugen oder auch für Fahrzeugdächer einsetzbar ist.

### Stand der Technik

Sowohl beim Einsatz an Gebäuden als auch in Kraftfahrzeugen werden hohe Anforderungen an die mechanische Festigkeit und Stabilität solcher Bauelemente gestellt. So müssen diese Bauelemente beim Einsatz in Fassaden insbesondere durch Windbelastungen hohen Zug- und Druckkräften standhalten. Zudem dürfen auch bei einer Beschädigung des Bauelements nicht einzelne Bestandteile von der Fassade herabfallen. Beim Einsatz als Deckel in Kraftfahrzeugen muss ein solches Bauelement ebenfalls hohen Zug- und Druckkräften widerstehen. Insbesondere können bei Unfällen kurzfristige, extrem starke Belastungen auftreten. Auch in solchen Situationen dürfen sich nicht einzelne Bestandteile von dem Bauelement lösen. Es soll hier das ganze Bauelement fest am Fahrzeug gehalten werden.

In der DE 10 2004 059959 A1 ist ein Bauelement zur Verglasung eines Bauwerks offenbart. Es weist eine Glasplatte auf, an deren Unterseite Solarzellen angebracht sind. Weiterhin ist auf der Rückseite der Solarzellen eine Splitterschutzfolie vorgesehen. Eine solche Splitterschutzfolie ist üblicherweise fest durch Laminieren mit den Solarzellen und mit der Glasplatte verbunden. Sie kann somit das Herausfallen von einzelnen Splittern aus der Glasplatte verhindern. Weiterhin offenbart dieses Dokument eine mechanische Befestigung der Splitterschutzfolie, um die mechanische Stabilität weiter zu erhöhen. Nachteilig an dieser Anordnung ist der höhere Fertigungsaufwand durch die separate Befestigung der Splitterschutzfolie, sowie eine begrenzte Wirksamkeit der Maßnahme durch die begrenzte Reißfestigkeit der Splitterschutzfolie.

In der EP 1 006 593 B1 ist ein Solarmodul mit einem integrierten Steckverbinder offenbart. Dieser ermöglicht eine besonders einfache elektrische Verbindung mit dem Solarmodul.

Für Fahrzeuge gibt es eine Vielzahl gesetzlicher Regelungen, die die Sicherheit von Fahrzeuginsassen sowie von Fußgängern betreffen. So definiert z.B. in den USA der Code of Federal Regulations in title 49, §571.208 ein Head Injury Criteria (HIC) als Maß für das Risiko von Kopfverletzungen bestimmter Schwere beim Aufprall auf Karosserieteile. Dieser Wert kann aus Messungen oder Simulationen errechnet werden und darf bestimmte Grenzwerte nicht überschreiten.

### Darstellung der Erfindung

Der Erfindung liegt die Aufgabe zugrunde, ein Bauelement mit Solarzellen für ein Kraftfahrzeug und insbesondere für die Oberfläche oder die Motorhaube eines Kraftfahrzeugs oder auch zur Verglasung eines Bauwerks sowie ein Verfahren zur Herstellung eines solchen Bauelements derart auszugestalten, dass dieses eine erhöhte mechanische Stabilität und Festigkeit aufweist. Gleichzeitig sollen die notwendigen Normen, wie z.B. der HIC-Wert erfüllt werden. Weiterhin soll die mit Solarzellen bestückbare Fläche vergrößert werden. Zudem soll es mit relativ geringem Aufwand zu geringen Kosten herstellbar sein.

Diese Aufgabe wird durch eine Vorrichtung nach Anspruch 1 gelöst. Vorteilhafte Ausgestaltungen der Erfindung sind in den Unteransprüchen angegeben.

Ein erfindungsgemäßes Bauelement umfasst eine Glasscheibe mit wenigstens einer Solarzelle. Die Glasscheibe umfasst bevorzugt ein Einscheiben-Sicherheitsglas (ESG), welches bevorzugt durch eine spezielle Wärmebehandlung eine erhöhte Stoß- und Schlagfestigkeit aufweist. Das Bauelement kann von der Größe und Form an das jeweilige Einsatzgebiet, wie beispielsweise für eine Gebäudefassade oder für ein Kraftfahrzeug, ausgelegt sein. Es kann auch eine Einfärbung oder eine Bedruckung aufweisen. Das Bauelement ist bevorzugt zu einer Verklebung mit einer Karosserie eines Fahrzeugs oder einem Halterahmen beispielsweise einer Fassade vorgesehen.

Unter der Glasscheibe befindet sich wenigstens eine Solarzelle. Diese wenigstens eine Solarzelle ist so auf der Unterseite bzw. Innenseite der Glasscheibe angeordnet, so dass sie durch die Glasscheibe von Umwelteinflüssen geschützt ist. Glasscheibe und Solarzellen haben bevorzugt ähnliche thermische Ausdehnungskoeffizienten, so dass auch bei Erwärmung keine mechanischen Spannungen auftreten. Bevorzugt ist eine größere Anzahl von Solarzellen, besonders bevorzugt in einer matrixförmigen Anordnung vorgesehen, um eine wirtschaftliche Herstellung zu ermöglichen. Um eine höhere und damit leichter zu verarbeitende Ausgangsspannung zu erreichen, werden die Solarzellen bevorzugt hintereinander (in Serie) geschaltet. Grundsätzlich ist aber auch eine Parallelschaltung oder eine kombinierte Serien-/Parallelschaltung möglich. Zur Verbindung der Solarzellen untereinander sind Zellverbinder vorgesehen. Durch derartige Zellverbinder werden bevorzugt benachbarte Solarzellen miteinander verbunden. Zudem dienen diese Zellverbinder auch zum äußeren Anschluss der Solarzellen, um sie beispielsweise mit einer Last oder einem Verbraucher zu verbinden. Die wenigstens eine Solarzelle ist bevorzugt fest mit der Glasscheibe verbunden. Eine solche Verbindung kann durch Aufkleben, Laminieren oder ein anderes, dem Stand der Technik entsprechendes Befestigungsverfahren erfolgen.

Bevorzugt ist die wenigstens eine Solarzelle mit Hilfe wenigstens einer Zwischenfolie auf die Glasscheibe laminiert. Es ist hierbei wenigstens eine zweite Zwischenfolie zwischen der wenigstens einen Solarzelle und der Glasscheibe vorgesehen. Wenigstens eine erste Zwischenfolie ist auf der der Glasscheibe abgewandten Seite der wenigstens einen Solarzelle vorgesehen, so dass die wenigstens eine Solarzelle zwischen der ersten Zwischenfolie und der Glasscheibe eingeschlossen ist. Besonders bevorzugt ist es, wenn die erste und/oder zweite Zwischenfolie eine Ethyl-Vinyl-Acetat-Folie (EVA) oder eine Polyvinyl-Butyral-Folie (PVB) ist. Die Dicke dieser Zwischenfolien kann in einem Bereich zwischen 0,2mm und 1mm liegen. Besonders günstig ist eine Dicke zwischen 0,3mm und 0,5mm. Derartige Zwischenfolien sind elastisch und haben eine hohe Reißfestigkeit. Durch den Einsatz einer solchen Zwischenfolie kann eine hohe Splitterfestigkeit des Bauelements erreicht werden.

Eine weitere Erhöhung der Stabilität kann durch ein Substrat unter der ersten Zwischenfolie erreicht werden. Das Substrat umfasst bevorzugt ein mechanisch steifes Material wie beispielsweise einen Glasfaser- oder Kohlefaser-Verbundwerkstoff. Die Dicke des Materials kann in einem Bereich von 0,1mm bis 5mm liegen. Günstiger ist ein Bereich zwischen 0,2mm und 2mm und besonders günstig ist eine Dicke von 0,4mm. Bevorzugt hat das Substrat einen ähnlichen thermischen Ausdehnungskoeffizienten wie das Glas. Bevorzugt differieren die Ausdehnungskoeffizienten von Glas und Substrat um weniger als 30%, besonders bevorzugt weniger als 20%. Am günstigsten ist es, wenn die Ausdehnungskoeffizienten weniger als 10% differieren. Die Eigenschaften des Substrates sind bevorzugt durch einen mehrlagigen Aufbau einstellbar.

Das Substrat hat eine wichtige Stabilisierungs- und Schutzfunktion. Bei einem schwachen Aufprall (von oben bzw. außen auf das Bauelement) haben die über dem Glas liegenden Folienschichten eine Dämpfungsfunktion. Bei einem starken Aufprall kann das Glas zersplittern. Hier bleibt aber zunächst der flächige Verbund zwischen den oberen Folienschichten und den Fragmenten der Glasscheibe intakt. Ebenso bleibt der flächige Verbund zwischen den Fragmenten der Glasscheibe und dem Substrat erhalten. Damit sorgt das Substrat für ein Zerreißen des Folienverbundes und Durchdringen des aufschlagenden Objektes. Zudem sorgt das Substrat für eine hohe Dämpfung des Aufpralls.

Um schließlich eine für den Einsatz in Motorhauben ausreichende Stabilität zu erzielen, wird noch eine bevorzugt mittelharte Schutzfolie mittels einer dritten Zwischenfolie auf der Oberseite der Glasplatte befestigt. Besonders bevorzugt ist es, wenn wenigstens eine der hier beschriebenen Zwischenfolien eine Ethyl-Vinyl-Acetat-Folie (EVA) oder eine Polyvinyl-Butyral-Folie (PVB) ist. Die dritte Zwischenfolie kann die zuvor beschriebenen Eigenschaften einer ersten bzw. zweiten Zwischenfolie aufweisen. Zur weiteren Erhöhung der Stabilität kann über der Schutzfolie noch eine vierte Zwischenfolie und darüber eine zweite Schutzfolie angebracht sein. Damit kann eine höhere Stabilität und auch eine bessere Dämpfung erreicht werden. Die Dicke der Schutzfolie kann in einem Bereich von 0,1mm bis 5mm liegen. Günstiger ist ein Bereich zwischen 0,2mm und 2mm und besonders günstig ist eine Dicke von 0,3mm. Die Schutzfolien umfassen bevorzugt PTFE (Polytetrafluorethylen), z.B. TEFLON.

Nachfolgend sind noch einige besondere Ausgestaltungen beschrieben, die sich auf alle hierin dargestellten Ausführungsformen beziehen, sofern nicht ausdrücklich anders erwähnt. In allen hier offenbarten Ausführungsformen ist die Glasscheibe bevorzugt durch ein Kunststoffmaterial, besonders bevorzugt in Form einer Zwischenfolie mit den anderen Komponenten verbunden. Besonders bevorzugt ist es, wenn eine solche Zwischenfolie eine Ethyl-Vinyl-Acetat-Folie (EVA) oder eine Polyvinyl-Butyral-Folie (PVB) ist. Derartige Zwischenfolien zeichnen sich durch hohe mechanische Stabilität und hohe Reißfestigkeit aus. Durch den Einsatz einer solchen Zwischenfolie kann eine hohe Splitterfestigkeit des Bauelements erreicht werden.

Ein erfindungsgemäßes Verfahren betrifft die Herstellung eines Bauelements für die Fassade eines Bauwerks oder für den Deckel eines Fahrzeugs. Dieses Verfahren umfasst die Schritte Bereitstellen einer Glasscheibe sowie die Anordnung wenigstens einer Solarzelle an dieser Glasscheibe, die Anordnung weiterer Folie bzw. Folienschichten wie hier dargestellt und schließlich das Verkleben bzw. Laminieren der beiden Glasscheiben zu einer Verbundglasscheibe. In weiteren Ausgestaltungen des Verfahrens sind die Schritte zur Herstellung der entsprechenden Ausführungsformen wie oben beschrieben inbegriffen.

### Beschreibung der Zeichnungen

Die Erfindung wird nachstehend ohne Beschränkung des allgemeinen Erfindungsgedankens anhand von Ausführungsbeispielen unter Bezugnahme auf die Zeichnungen exemplarisch beschrieben.
Figur 1 zeigt eine bevorzugte Ausführungsform im Schnitt
Figur 2 zeigt eine bevorzugte Ausführungsform im Schnitt
Figur 3 zeigt ein erfindungsgemäßes Bauelement in einer Draufsicht.

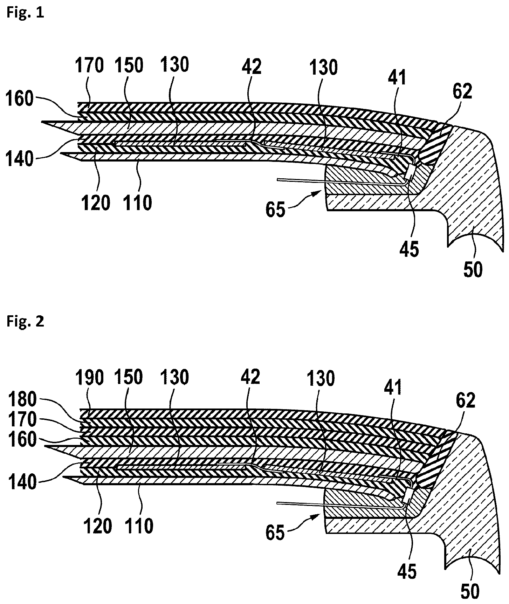

Die Figur 1 zeigt eine erfindungsgemäße Anordnung im Schnitt. An der Unterseite des Schichtaufbaus liegt ein Substrat 110, welches bevorzugt eine Kunststoffplatte, wie eine GFK- oder CFK-Platte sein kann. Ebenso wäre hier auch der Einsatz eines dünnen Blechs z.B. aus Aluminium umfassend ein Metall oder eine Kombination von Kunststoff bzw. Metall möglich. Bevorzugt ist eine Honeycomb-Struktur. Auf diesem Substrat 110 befindet sich eine erste Zwischenfolie zur Einbettung von Solarzellen 130 zusammen mit der zweiten Zwischenfolie 140, welche über der ersten Zwischenfolie angeordnet ist. Oberhalb der zweiten Zwischenfolie 140 ist eine Glasscheibe 150, welche bevorzugt ESG-Glas (Einscheibensicherheitsglas) umfasst. Diese Glasscheibe kann aber auch Verbundglas mit zwei Glasscheiben und einer Zwischenfolie umfassen. Oberhalb der Glasscheibe ist eine dritte Zwischenfolie 160 mit einer darüber angeordneten Schutzfolie 170 angeordnet. Durch diese beiden Folien auf der Glasscheibe ergibt sich einerseits ein Schutz der Glasscheibe und gleichzeitig ein verbessertes Aufprallverhalten, da hier nun die beiden Folienschichten zur Kraftverteilung und Dämpfung des Aufpralls beitragen. Erst durch einen solchen Schichtaufbau sind die gesetzlichen Regelungen zur Sicherheit von Fußgängern einzuhalten.

In diesem Schnitt sind noch weitere Details vorteilhafter Ausführungsformen, insbesondere zur Abdichtung und zum Anschluss der Solarzellen dargestellt. So sind die Solarzellen bevorzugt durch Zellverbinder 41, 42 miteinander verbunden. Verschiedene Zellverbinder 41 können durch Querverbinder 45 wiederum miteinander verbunden werden. Zur Verbindung des Schichtaufbaus mit einer Karosserie bzw. einem Rahmen 50 kann eine Verklebung 65 und/oder eine äußere Dichtung 62 vorgesehen sein.

Die Figur 2 zeigt eine ähnliche Anordnung wie die Figur 1. Hierbei sind zusätzlich oberhalb der Schutzfolie eine vierte Zwischenfolie 180 und wiederum darüber eine zweite Schutzfolie 190 angeordnet. Hierdurch ergibt sich eine noch günstigere Dämpfung sowie eine noch günstigere Krafteinleitung eines aufprallenden Gegenstandes in das Bauelement.

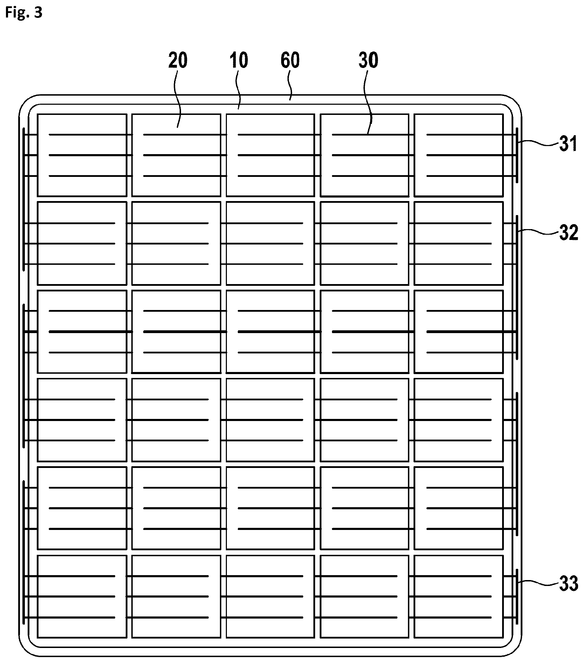

In Figur 3 ist ein erfindungsgemäßes Bauelement insbesondere für die Motorhaube eines Fahrzeugs schematisch in der Draufsicht dargestellt. Das Bauelement umfasst eine obere Glasscheibe 10. Die Glasscheibe kann jede beliebige, der Aufgabe angepasste Form aufweisen. So kann sie beispielsweise abgerundete Ecken haben, wie in der Figur dargestellt. Ebenso kann sie in einer oder zwei Achsen gewölbt sein, oder eine andere freie, gekrümmte Form aufweisen, um sie beispielsweise an die Kontur eines Fahrzeugdachs anzupassen. Anstelle einer rechteckigen Form kann sie auch beliebige andere Formen haben. Bevorzugt hinter bzw. unter der oberen Glasscheibe und somit vor äußeren Umwelteinflüssen geschützt, ist wenigstens eine Solarzelle 20 angeordnet. In diesem Ausführungsbeispiel sind 30 Solarzellen in 6 Reihen mit jeweils 5 Solarzellen unter der Glasscheibe angeordnet. Grundsätzlich kann jede andere Anzahl von Solarzellen verwendet werden. Es müssen auch nicht quadratische Solarzellen, wie hier dargestellt verwendet werden. Die Solarzellen können grundsätzlich jede beliebige Form, auch rund, haben. Die elektrische Kontaktierung der Solarzellen 20 erfolgt durch Zellverbinder 30.

In dem hier dargestellten Beispiel sind die Solarzellen hintereinander geschaltet, so dass ein Zellverbinder von einer Solarzelle eine benachbarte Solarzelle kontaktiert. Die einzelnen Reihen von Solarzellen sind durch Querverbinder 31, 32 und 33 kontaktiert. Die Querverbinder 32 sind zur Verbindung von Reihen untereinander vorgesehen, während die Querverbinder 31 und 33 zur Kontaktierung der ersten bzw. letzten Solarzelle der Anordnung dienen. Es kann hier an die Querverbinder 31 und 33 ein Stromverbraucher bzw. eine Last angeschlossen werden, welche durch den Strom aus den Solarzellen gespeist wird.

Weiterhin ist noch der Rahmen 60 dargestellt, der die Glasscheiben umschließt. Hier ist ein umlaufender Rahmen dargestellt. Es ist aber offensichtlich, dass dieser auch nur bestimmt Abschnitte umfassen kann. So könnte beispielsweise ein Rahmen aus Segmenten mit Lücken zwischen den einzelnen Segmenten bestehen.

Bevorzugt ragt wenigstens ein äußerer Zellverbinder 30 der Solarzellen 20 an deren Enden in den Rahmen 60 hinein. Weiterhin sind bevorzugt die Querverbinder 31, 32 und 33 in dem Rahmen bzw. in die Verklebung eingeschlossen. Dadurch, dass die Zellverbinder benachbarte Solarzellen einer jeden Zeile miteinander verbinden, ergibt sich eine kettenartige Struktur von miteinander verbundenen Solarzellen, welche wiederum über die äußeren Zellverbinder in dem Rahmen befestigt ist. Versuche haben ergeben, dass diese Struktur eine sehr hohe mechanische Stabilität aufweist und damit zur Gesamtstabilität des Bauelements wesentlich beiträgt. So kann hierdurch die notwendige Kraft zum Herausreißen des Bauelements aus einer äußeren Halterung wesentlich erhöht werden, was die Robustheit und Zuverlässigkeit bei Fassadenelementen und die Unfallsicherheit bei Deckeln für Kraftfahrzeuge deutlich erhöht.

### Bezugszeichenliste

- 10: Glasscheibe
- 20: Solarzelle
- 30: Zellverbinder
- 31, 32, 33, 45: Querverbinder
- 41, 42: Zellverbinder
- 50: Karosserie / Rahmen
- 60: Rahmen
- 62: äußere Dichtung
- 65: Verklebung
- 110: Substrat
- 120: erste Zwischenfolie
- 130: Solarzellen
- 140: zweite Zwischenfolie
- 150: Glasscheibe
- 160: dritte Zwischenfolie
- 170: Schutzfolie
- 180: vierte Zwischenfolie
- 190: zweite Schutzfolie

## Patentansprüche

1. Bauelement für die Oberfläche oder Motorhaube eines Fahrzeugs, umfassend einen Schichtaufbau in der folgenden Reihenfolge mit einem Substrat (110),
einer ersten Zwischenfolie (120),
wenigstens einer Solarzelle (130),
einer zweiten Zwischenfolie (140),
einer Glasscheibe (150),
einer dritten Zwischenfolie (160) und
einer Schutzfolie (170).

2. Bauelement nach Anspruch 1,
**dadurch gekennzeichnet, dass**
auf der Schutzfolie (170) eine vierte Zwischenfolie (180) und darauf eine zweite Schutzfolie (190) angeordnet ist.

3. Bauelement nach einem der vorhergehenden Ansprüche,
**dadurch gekennzeichnet, dass**
wenigstens eine aus der ersten Zwischenfolie (120), der zweiten Zwischenfolie (140), der dritten Zwischenfolie (160) und der vierten Zwischenfolie (180) eine Ethyl-Vinyl-Acetat-Folie (EVA) oder eine Polyvinyl-Butyral-Folie (PVB) ist.

4. Bauelement nach einem der vorhergehenden Ansprüche,
**dadurch gekennzeichnet, dass**
die Dicke wenigstens einer der Zwischenfolien im Bereich von 0,1mm bis 5mm liegt.

5. Bauelement nach einem der vorhergehenden Ansprüche,
**dadurch gekennzeichnet, dass**
die Dicke wenigstens einer der Zwischenfolien im Bereich von 0,2mm bis 2mm liegt.

6. Bauelement nach einem der vorhergehenden Ansprüche,
**dadurch gekennzeichnet, dass**
wenigstens eine der Schutzfolien Polytetrafluorethylen umfasst.

7. Bauelement nach einem der vorhergehenden Ansprüche,
**dadurch gekennzeichnet, dass**
das Substrat (110) ein mechanisch steifes Material wie einen Glasfaser- oder Kohlefaser- Verbundwerkstoff umfasst.

8. Bauelement nach einem der vorhergehenden Ansprüche,
**dadurch gekennzeichnet, dass**
die Dicke des Substrats (110) im Bereich von 0,1mm bis 5mm liegt.

9. Bauelement nach einem der vorhergehenden Ansprüche,
**dadurch gekennzeichnet, dass**
die Dicke des Substrats (110) im Bereich von 0,2mm bis 2mm liegt.

10. Bauelement nach einem der vorhergehenden Ansprüche,
**dadurch gekennzeichnet, dass**
die Glasscheibe (150) ein Sicherheitsglas (ESG) umfasst, welches bevorzugt durch eine spezielle Wärmebehandlung eine erhöhte Stoß- und Schlagfestigkeit aufweist.

11. Bauelement nach einem der Ansprüche 1 bis 9,
**dadurch gekennzeichnet, dass**
die Glasscheibe (150) ein Verbundglas umfasst.

12. Bauelement nach einem der vorhergehenden Ansprüche,
**dadurch gekennzeichnet, dass**
das Bauelement und/oder die Folien laminiert sind.

13. Bauwerk oder Fahrzeug umfassend wenigstens ein Bauelement nach einem der vorhergehenden Ansprüche.
